# DEMANDE DE BREVET EUROPEEN

(11) **EP 2 755 041 A2**
(43) Date de publication de la demande: **16.07.2014**
(21) Numéro de dépôt: 14150263.3
(22) Date de dépôt: 07.01.2014
(51) Int. Cl.: G01R 33/60, G01N 21/64

(54) **Dispositif de caractérisation d'un matériau par RPE et photoluminescence**

(30) Priorité: 09.01.2013 FR 1350167
(71) Demandeur: Commissariat à l'Énergie Atomique et aux Énergies Alternatives, 75015 Paris (FR); Centre National de la Recherche Scientifique, 75016 Paris (FR)
(72) Inventeur: Pepin-Donat, Brigitte, 38700 CORENC (FR); Lombard, Christian, 38100 GRENOBLE (FR); De Sousa nobre, Sonia, 38100 GRENOBLE (FR); Renard, Olivier, 38120 FONTANIL-CORNILLON (FR); Le Blevennec, Gilles, 38190 BERNIN (FR)
(74) Mandataire: GIE Innovation Competence Group

(57) **Abrégé**

L'invention concerne un dispositif de caractérisation d'un matériau (1), comprenant :
-un spectromètre de résonance paramagnétique électronique (2), incluant :
-une cavité résonnante (41) configurée pour recevoir un échantillon (91) d'un matériau à caractériser et susceptible d'entretenir une onde stationnaire micro-ondes;
-un récepteur (21) de résonance paramagnétique électronique configuré pour mesurer la résonance paramagnétique électronique dans la cavité résonnante ;

-une source de lumière (32) configurée pour illuminer l'échantillon placé à l'intérieur de la cavité résonnante (41) ;
-un dispositif de réception de la lumière émise par l'échantillon éclairé (31) comportant une entrée optique (33) logée à l'intérieur de la cavité résonnante.

## Description

L'invention concerne la caractérisation des matériaux, et en particulier les dispositifs permettant de caractériser un matériau de façon simple et fiable, présentant par exemple une application dans le domaine de l'authentification ou du marquage de produits. Différentes techniques de caractérisation de matériaux sont connues.

Une technique connue est notamment la résonance paramagnétique électronique, dénommée par la suite RPE. La RPE est une technique de mesure physique locale permettant d'obtenir des informations concernant la nature des espèces comprenant des électrons célibataires, ainsi que des informations sur leurs concentrations, leur réactivité, leur environnement, leur dynamique et les interactions magnétiques entre ces espèces et avec d'autres espèces magnétiques.

La RPE est une méthode de spectroscopie sous champ magnétique. Grâce à sa spécificité et sa grande sensibilité, elle permet une détection directe des espèces paramagnétiques (radicaux libres, éléments de transition, défauts de structure...) caractérisées par la présence d'un ou plusieurs électron(s) non apparié(s) sur la couche de valence. Le cas usuel où plusieurs électrons non appariés (S > 1/2) interviennent est celui des éléments de transitions.

Le principe de la RPE repose sur l'effet Zeeman : soumis à l'action d'un champ magnétique extérieur H, les niveaux d'énergie d'un spin S se séparent en (2S + 1) états, chacun affecté d'un nombre quantique m_{S} (m_{S} = -S, -S+1, - S+2, ..., S). Cette séparation des niveaux est d'autant plus grande que H est intense. Ainsi, pour le cas d'un seul électron célibataire (donc pour lequel S = 1/2), la présence du champ magnétique extérieur donne lieu à (2S + 1) = 2 états, correspondant à m_{S} = -1/2 et m_{S} = +1 /2. L'énergie magnétique associée à chacun de ces états est donnée par m_{S} * g * µB * H, où g est le facteur de Landé. Lorsqu'il s'agit d'un électron libre, gₑ vaut 2,0023. Dans le cas général, le facteur g est différent de ge, et µ_{B} (parfois noté β) est le magnéton de Bohr. Puis, sous l'action d'un second champ magnétique (champ hyperfréquence ou micro-onde) perpendiculaire au premier et d'amplitude beaucoup plus faible, ayant une fréquence v, un photon d'énergie hv peut être absorbé (ou émis) si la séparation énergétique entre les 2 niveaux concernés, c'est-à-dire g * µ_{B} * H, se trouve égale à hv. C'est à cette valeur particulière de H qu'un phénomène de résonance se produit.

La RPE est utile pour l'étude de la structure locale de l'ensemble des matériaux pouvant présenter en leur sein au moins un électron célibataire, qui sert en quelque sorte de sonde pour le scruter. Elle peut servir à l'étude, par exemple, de la structure de défauts créés par le passage d'un rayonnement (α, β, y, particules chargées...), et permettre en même temps une mesure absolue de leur concentration dans la structure. La RPE permet d'étudier des structures organiques ou minérales, ou hybrides.

En Science des Matériaux, la spectroscopie de luminescence est une méthode de spectroscopie avec laquelle il est possible d'analyser la structure électronique des matériaux. En particulier, la spectroscopie de photoluminescence est un type de spectroscopie électromagnétique qui analyse l'émission d'un échantillon sous éclairement. Cette méthode implique l'utilisation d'un rayon de lumière (usuellement dans l'ultraviolet ou le visible) qui va exciter les électrons de certains composés et les fait émettre de la lumière de plus basse énergie par retour à l'état énergétique initial, typiquement de la lumière visible ou infrarouge.

Il serait donc intéressant de corréler les mesures de RPE et de photoluminescence afin de déterminer les relations entre les propriétés structurales et les propriétés optiques. Cependant, les contraintes externes liées aux mesures, telles que l'intensité et la longueur d'onde de l'éclairement, la lumière du jour, le taux d'oxygène environnant, la température locale, ont une importante influence sur les résultats.

Par exemple, la température locale de l'échantillon (qui joue un rôle crucial) ne peut être mesurée qu'avec une précision réduite par l'intermédiaire d'un thermocouple accouplé au porte échantillon, et qui ne mesure donc pas exactement la zone de l'échantillon en cours d'analyse. Lorsque l'échantillon n'est pas parfaitement homogène, ces analyses sont en outre fortement influencées par la position de l'échantillon analysé, qui détermine la composition de la zone en cours d'analyse. La spectrométrie optique est notamment sensible au nombre, à la nature et à la répartition spatiale des espèces optiquement actives. Des tests ont montré que l'analyse d'un même échantillon par photoluminescence pour différentes positions fournit des intensités mesurées présentant de très grandes disparités. La RPE détecte le type et la quantité des espèces paramagnétiques intrinsèques à l'échantillon ou créées dans la zone éclairée. Le spectre de RPE est donc sensible au nombre et à la structure des centres émetteurs.

De ce fait, l'exploitation d'un résultat d'une analyse de RPE et d'un résultat d'analyse de photoluminescence n'est pas actuellement réalisable.

Des études ont été effectuées pour étudier la corrélation entre les techniques de RPE et de photoluminescence, comme illustré par la publication du 02/04/2010 'Distance-dependent fluorescence quenching and binding of CdSe quantum dots by functionalized nitroxide radicals' dans J. Phys. Chem. C 2010, 114, 7793-7805. Cette publication mentionne notamment la probable corrélation entre les deux analyses pour certains types de composés mais n'ont pu la réaliser.

Si une telle corrélation entre les deux types d'analyses laisse envisager une amélioration de la caractérisation d'un matériau (et notamment la possibilité d'établir une relation entre propriétés optiques et propriétés électroniques), cette corrélation s'avère délicate à exploiter en pratique. Il n'y a pas de solution satisfaisante connue permettant d'exploiter une telle corrélation pour obtenir une précision de caractérisation sensiblement améliorée pour un matériau, chacune des analyses étant trop fortement influencée par les contraintes externes rencontrées. Du fait de la sensibilité des analyses aux contraintes externes, la corrélation entre les résultats d'une analyse RPE et d'une analyse par photoluminescence s'avère en pratique difficile à constater de façon reproductible.

L'invention vise à résoudre un ou plusieurs de ces inconvénients. L'invention porte ainsi sur un dispositif de caractérisation d'un matériau tel que défini dans les revendications annexées.

D'autres caractéristiques et avantages de l'invention ressortiront clairement de la description qui en est faite ci-après, à titre indicatif et nullement limitatif, en référence aux dessins annexés, dans lesquels :
- la figure 1 est une représentation schématique d'un dispositif de caractérisation d'un matériau selon un mode de réalisation de l'invention ;
- la figure 2 est une vue en section en perspective du dispositif de la figure 1 au niveau d'une cavité résonnante ;
- la figure 3 est une vue en coupe transversale schématique du dispositif au niveau de sa cavité résonnante ;
- la figure 4 est une vue de face schématique d'un exemple d'une optique de focalisation pour un dispositif de caractérisation selon l'invention ;
- la figure 5 illustre les mesures respectives effectuées par un capteur de photoluminescence et un capteur de résonance paramagnétique électronique ;
- la figure 6 illustre différents spectres de mesure de photoluminescence pour différentes positions d'un même échantillon.

L'invention propose un dispositif de caractérisation pour mener une analyse RPE et une analyse par photoluminescence simultanément sur une même zone d'un échantillon. En enregistrant en simultané le spectre de RPE et le spectre de photoluminescence sur un même échantillon, on dispose de conditions rigoureusement identiques (quantité et nature de la matière analysée, taux d'humidité, d'oxygène, température...). On peut ainsi établir une corrélation entre les propriétés optiques et les espèces paramagnétiques qui peuvent être à leur origine. L'invention permet notamment de réaliser des mesures RPE et des mesures de photoluminescence avec une même source lumineuse.

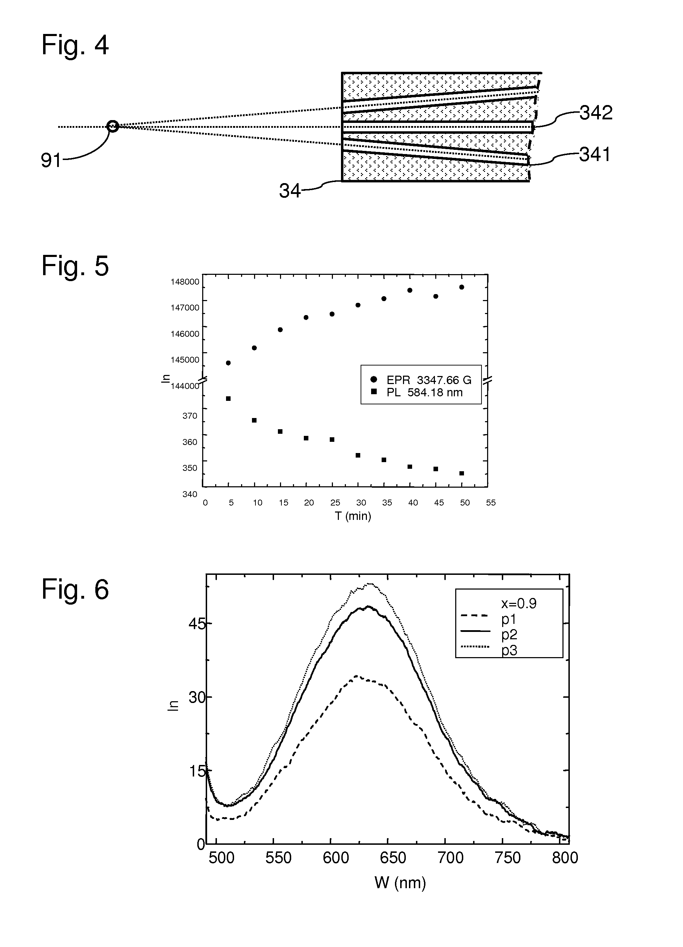

La figure 6 illustre un exemple de spectre de photoluminescence obtenu pour un même échantillon de matière, pour différentes positions de cet échantillon. Ces spectres permettent bien d'illustrer que même si ils ont une forme similaire, leurs amplitudes respectives varient fortement en fonction de la position de l'échantillon. En réalisant une mesure de RPE et une mesure de photoluminescence en simultané sur une même zone de matière, on évite l'incertitude sur les variations d'amplitude de mesure liée à un changement de position de l'échantillon entre la mesure de RPE et la mesure de photoluminescence. Ainsi, le dispositif permet de caractériser un matériau par une corrélation significative entre une mesure de RPE et une mesure de photoluminescence. Un dispositif de caractérisation selon l'invention permet en outre d'envisager une utilisation itinérante ou une utilisation industrielle, le temps de caractérisation pouvant être réduit du fait des mesures simultanées de RPE et de photoluminescence, et du fait que le contraintes externes ne sont plus à contrôler.

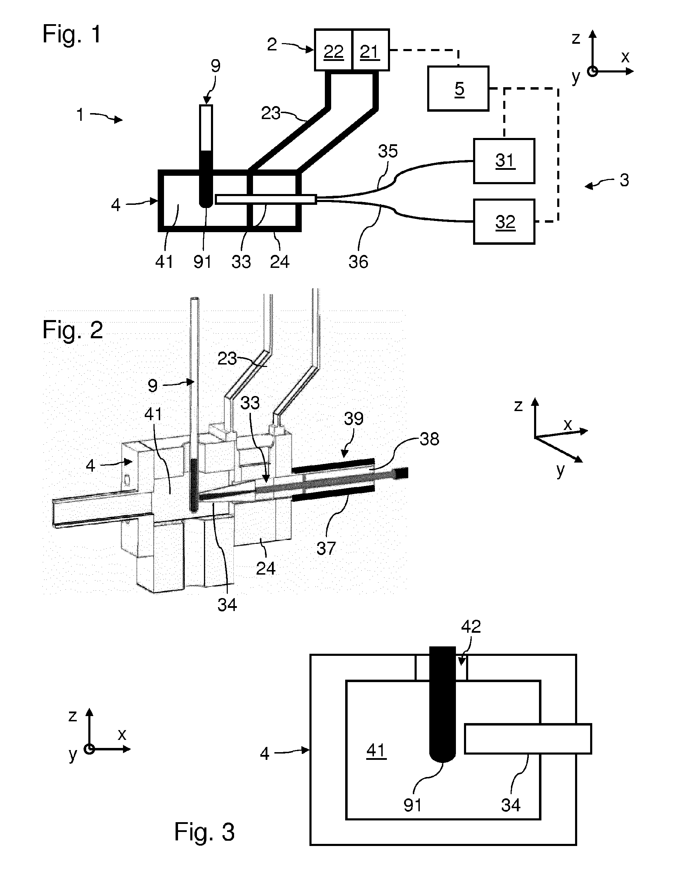

La figure 1 est une représentation schématique d'un dispositif de caractérisation 1 d'un matériau, selon un mode de réalisation de l'invention. Le dispositif de caractérisation 1 comprend un dispositif de résonance paramagnétique électronique 2, un dispositif d'analyse par photoluminescence 3, un boîtier de résonance RPE 4 et un système de contrôle 5. Le dispositif de caractérisation 1 comprend en outre un module de génération d'un champ magnétique statique non illustré, configuré pour appliquer un champ magnétique statique dans le boîtier de résonance RPE 4, avec une amplitude appropriée.

Le boîtier de résonance 4 délimite une cavité résonnante 41 destinée à recevoir un échantillon de matière 91 logé dans un porte échantillon 9. L'échantillon de matière 91 peut être en phase liquide, solide ou gazeuse, être opaque ou transparent. Dans l'exemple illustré, le boîtier de résonance 4 comprend une ouverture supérieure pour l'introduction d'une extrémité du porte échantillon 9 dans la cavité résonnante 41. La cavité résonnante 41 (et donc l'échantillon 91 disposé dans cette cavité résonnante) est donc soumise au champ magnétique statique appliqué. La cavité résonnante 41 présente ici une forme de parallélépipède rectangle. Le porte échantillon 9 peut être de façon connue en soi un tube de quartz de 3 mm de diamètre intérieur. Les figures 2 et 3 sont respectivement des vues en perspective et en coupe transversale au niveau de la cavité résonnante 41.

Le dispositif de résonance paramagnétique électronique 2 comprend d'une part un module de détection RPE 21 et d'autre part un module d'excitation RPE 22, par exemple une source micro-ondes opérant à une fréquence voisine de 9 GHz (bande X). Le dispositif de résonance paramagnétique électronique 2 comprend en outre de façon connue en soi un guide d'onde 23 et un adaptateur 24. Le guide d'onde 23 permet la propagation des micro-ondes entre l'adaptateur 24 d'une part et le module de détection 21 et le module d'excitation 22 d'autre part. L'adaptateur 24 présente une ouverture en communication avec la cavité résonnante 41 et permet de façon connue en soi d'assurer la propagation des micro-ondes entre le guide d'onde 23 et la cavité résonnante 41.

Le dispositif d'analyse par photoluminescence comprend un dispositif de réception optique (incluant un récepteur photosensible 31 convertissant l'énergie lumineuse dans une gamme donnée en signal électrique), et une source lumineuse ou module d'éclairement 32, des guides lumineux 35 et 36 et un embout 33. Le guide lumineux 35 est destiné à conduire avec le minimum de perturbations un signal lumineux de la cavité résonnante 41 jusqu'au récepteur photosensible 31. Le guide lumineux 36 est destiné à conduire avec le minimum de perturbations un signal lumineux de la source lumineuse 32 jusqu'à la cavité résonnante 41. L'embout 33 inclut les extrémités des guides lumineux 35 et 36. L'extrémité libre de l'embout 33 est en saillie à l'intérieur de la cavité résonnante 41. L'extrémité libre de l'embout 33 forme l'entrée optique du récepteur photosensible 31 et la sortie optique de la source lumineuse 32. Une telle configuration permet de placer le guide lumineux 35 au plus près de l'échantillon 91. Ainsi, on peut disposer d'un signal lumineux d'une amplitude et d'une précision suffisante sur le récepteur photosensible 31 pour obtenir le spectre optique de photoluminescence (luminescence dans la gamme de longueur d'onde allant par exemple de l'ultraviolet à l'infrarouge, par exemple entre 100nm et 1 mm de longueur d'onde). Une autre réalisation envisageable est de dissocier les entrées et sortie optiques. Par exemple, la lumière renvoyée par l'échantillon peut être collectée dans une autre direction que celle de la lumière incidente (par exemple 90° ou 180° en particulier pour un échantillon transparent).

Les inventeurs ont noté de façon surprenante que le placement de l'extrémité de l'embout 33 à l'intérieur de la cavité résonnante 41 permettait d'obtenir un signal lumineux de réponse présentant une amplitude satisfaisante, sans pour autant détériorer le fonctionnement de la mesure RPE. En effet, l'homme du métier est normalement dissuadé d'introduire tout élément autre que l'échantillon 91 dans la cavité résonnante 41, du fait de la sensibilité de cette cavité 41 à toutes perturbations extérieures et du fait de la précision requise dans les réglages des paramètres de cette cavité 41 pour atteindre sa résonance.

L'embout 33 traverse ici l'adaptateur 24 et est en saillie à l'intérieur de la cavité 41 à travers l'ouverture de communication entre la cavité 41 et l'adaptateur 24. Les guides lumineux 35 et 36 incluent avantageusement de la fibre optique. Une ou plusieurs fibres optiques peuvent être utilisées pour former le guide lumineux 35 ou le guide lumineux 36. Les fibres optiques des guides lumineux 35 et 36 peuvent notamment appartenir à une même fibre multibrins. Les fibres optiques sont avantageusement disposées dans une gaine de protection. Avantageusement, la gaine de protection des fibres optiques inclut un revêtement de protection polymère, par exemple en polyimide, en silicone, en acrylate haute température, ou en fluoroacrylate. Le contenu de l'embout 33 (tout au moins la partie destinée à être introduite dans la cavité 41), est avantageusement dépourvu d'éléments métalliques, afin de ne pas perturber la mesure RPE dans la cavité résonnante 41. Le diamètre de l'embout 33 est compatible avec la dimension de l'ouverture entre la cavité optique 41 et l'adaptateur 24. Le diamètre de l'embout 33 est par exemple inférieur ou égal à 4mm.

Une extrémité libre 34 de l'embout 33 peut inclure à la fois l'entrée optique vers le récepteur photosensible et la sortie optique provenant de la source lumineuse. L'embout 33 peut être muni d'une pluralité de fibres optiques de sortie 341 et d'une fibre optique d'entrée 342, comme illustré sur la vue en coupe de la figure 4. Les fibres optiques de sortie 341 sont avantageusement réparties autour de la fibre optique d'entrée 342 (on peut par exemple utiliser 6 fibres optiques 341 réparties autour de la fibre optique d'entrée 342). Les fibres optiques 341 sont accouplées à une ou plusieurs fibres optiques du guide lumineux 36. La fibre optique 342 est par exemple formée de l'extrémité d'une fibre optique du guide lumineux 35. Les axes optiques des fibres optiques de sortie 341 convergent avantageusement en un même point, sur l'axe optique de la fibre optique 342. Ce point est situé dans la cavité 41 à l'avant de l'entrée optique de la fibre optique 342, c'est-à-dire au niveau où doit être placé l'échantillon 91. L'axe optique de la fibre optique 342 est dans l'axe de l'échantillon et parallèle à la direction X. Une telle configuration permet d'apporter une excitation lumineuse suffisante sur l'échantillon 91, tout en présentant une sensibilité de mesure moindre à la distance entre l'échantillon 91 et la fibre optique 342.

Dans l'exemple illustré, le porte échantillon 9 est introduit dans la cavité 41 selon un axe Z. Le boîtier de résonance 4 peut par exemple guider le porte échantillon 9 en translation selon la direction Z, en fixant ainsi sa position selon l'axe X et l'axe Y. L'axe optique de l'entrée du guide lumineux 35 de direction X est ainsi perpendiculaire à cette direction d'introduction. Le boîtier de résonance 4 comporte avantageusement un mécanisme de fixation permettant d'immobiliser le porte échantillon 9 en positionnant l'échantillon 91 sur l'axe optique de l'entrée du guide lumineux 35. Avantageusement, la position de l'embout 33 selon la direction X (et donc la distance entre l'échantillon 91 et cet embout 33) est réglable. Ce réglage permet de conserver un accord et un couplage de la cavité 41 acceptables. Dans le mode de réalisation illustré, le dispositif de caractérisation 1 comprend un mécanisme de réglage 39 de cette position. Le mécanisme de réglage 39 comprend ici un tube 37 dont la paroi intérieure est filetée et montée à rotation sur l'adaptateur 24 autour de l'axe X. L'embout 33 et les fibres optiques sont montés encastrés dans un manchon 38. La paroi extérieure du manchon 38 est filetée. Ainsi, par rotation du tube 37, on déplace le manchon 38, et donc l'embout 33, selon la direction X. Le tube 37 est avantageusement entraîné en rotation par l'intermédiaire d'un moteur commandé par le système de contrôle 5.

La course de l'embout 33 selon la direction X permet avantageusement d'amener son extrémité jusqu'à la position en X du porte échantillon 9, par exemple jusqu'à l'aplomb de l'ouverture 42 d'introduction du porte échantillon 9. De préférence, on doit pouvoir rapprocher l'embout 33 à moins de 5 mm du porte-échantillon. Dans l'exemple, la distance entre le porte échantillon 9 et l'embout 33 est définie en déplaçant l'embout 33. On peut également envisager de maintenir l'embout 33 fixe et de prévoir un réglage de la position du porte échantillon 9 selon la direction X.

Le manchon 38 est avantageusement amovible afin de permettre le changement des fibres optiques. Ainsi, des fibres optiques appropriées peuvent être utilisées selon le souhait de l'utilisateur. On peut même envisager d'utiliser des fibres optiques présentant une gaine métallique, la partie métallique pouvant par exemple être rapprochée jusqu'à l'ouverture de la cavité résonnante 41. Différentes fibres optiques peuvent ainsi être utilisées en fonction du matériau de l'échantillon 91 et d'un type de spectre de photoluminescence attendu.

Préalablement à une caractérisation d'un échantillon, le système de contrôle 5 peut commander la position selon la direction X de l'embout 33, par exemple afin de réaliser l'accord de la cavité résonnante 41. Pour cela, le système de contrôle 5 peut réaliser des échantillonnages de mesures RPE pour différentes positions de l'embout 33, pour déterminer quelle position correspond à un accord de la cavité résonnante 41.

Durant une phase de caractérisation d'un matériau, le système de contrôle 5 commande l'application simultanée d'un champ magnétique statique dans la cavité résonnante 41, l'application d'une excitation lumineuse par la source 32, l'application d'une excitation micro-ondes par le module 22, l'échantillonnage de mesures RPE par le module de détection 21 (on effectue ainsi des mesures RPE photo-induites) et l'échantillonnage de mesures de photoluminescence par le récepteur photosensible 31.

De façon connue en soi, la cavité 41 devient résonnante lorsque celle-ci absorbe l'essentiel de l'énergie micro-onde transmise par le module d'excitation 22.

Le système de contrôle 5 peut adapter la durée et la puissance d'application de l'excitation optique de la source 32 ou adapter la durée d'intégration de la mesure du récepteur photosensible 31. Ainsi, lorsque le matériau de l'échantillon 91 est peu luminescent, le système de contrôle 5 pourra commander une augmentation de la durée d'intégration du récepteur photosensible 31, une augmentation de la puissance d'émission de la source 32 ou un rapprochement entre l'embout 33 et l'échantillon 91.

La figure 5 illustre des résultats de mesures respectives effectuées par un récepteur photosensible 31 et un capteur RPE 21 en simultané sur un même échantillon 91. Les tests ont ici été effectués sous un éclairement d'intensité constante à une longueur d'onde de 473 nm. La RPE a été effectuée à une fréquence de 9 gigahertz. L'échelle d'intensité des mesures effectuées en RPE et en photoluminescence est ici arbitraire. L'intensité de RPE est mesurée en un point fixe du signal de RPE correspondant à une valeur prédéterminée du facteur g, et l'intensité de photoluminescence correspond à une longueur d'onde de 584,18 nm. Les résultats permettent de constater une corrélation temporelle très importante entre les mesures RPE et les mesures de photoluminescence. L'intensité de la mesure RPE augmente alors que l'intensité de la mesure de photoluminescence baisse.

Cette corrélation permet de démontrer que les centres paramagnétiques photoinduits sont bien liés à la photoluminescence et peut permettre de remonter aux mécanismes mis en jeu dans la dégradation des propriétés optiques des matériaux.

En l'absence d'une observation simultanée et d'une même zone de l'échantillon 91, il est ainsi impossible de relier les espèces responsables de la signature RPE à celles qui sont à l'origine des modifications du spectre de photoluminescence. Une mesure simultanée permet en outre d'éviter que des mesures de photoluminescence ne fassent apparaître de nouveaux centres paramagnétiques qui seraient ensuite détectés lors d'une mesure RPE ultérieure.

Dans le mode de réalisation décrit, un champ magnétique statique modulable et ajustable au facteur g des espèces observées est appliqué dans le boîtier de résonance 4 alors que la fréquence du champ micro-ondes reste sensiblement identique pour une expérience donnée, mais doit toutefois être mesurée de façon très précise lors de chaque expérience (ainsi que le champ magnétique statique) pour obtenir une mesure précise du facteur g et pour toute étude comparative de 2 spectres de RPE. Cependant, on peut également envisager d'appliquer une fréquence de champ micro-ondes différente (par exemple bien supérieure pour obtenir une meilleure résolution) ; il conviendra alors d'appliquer un champ magnétique variable dans le boîtier 4 de résonance, dont la valeur centrale sera adaptée au facteur g des espèces observées et à cette nouvelle fréquence.

## Revendications

1. Dispositif de caractérisation d'un matériau (1), **caractérisé en ce qu'**il comprend :
- un spectromètre de résonance paramagnétique électronique (2), incluant :
- une cavité résonnante (41) configurée pour recevoir un échantillon (91) d'un matériau à caractériser et susceptible d'entretenir une onde stationnaire micro-ondes;
- un récepteur (21) de résonance paramagnétique électronique configuré pour mesurer la résonance paramagnétique électronique dans la cavité résonnante ;
- une source de lumière (32) configurée pour illuminer l'échantillon placé à l'intérieur de la cavité résonnante (41), comportant une sortie optique (33) logée à l'intérieur de la cavité résonnante (41) ;
- un dispositif de réception de la lumière émise par l'échantillon éclairé (31) comportant une entrée optique (33) logée à l'intérieur de la cavité résonnante, ledit dispositif de réception de la lumière émise étant distinct du récepteur de résonance paramagnétique électronique ;
- un système de contrôle (5) configuré pour commander l'illumination de l'intérieur de la cavité résonnante (41) et pour commander un échantillonnage simultané par le récepteur de résonance paramagnétique électronique (21) et par le dispositif de réception de lumière (31).

2. Dispositif de caractérisation selon la revendication 1, dans lequel la source lumineuse (32) comprend au moins une fibre optique de sortie (36) formant un guide lumineux entre la source lumineuse et ladite sortie optique, et dans lequel le dispositif de réception de lumière (31) comprend un récepteur photosensible et au moins une fibre optique d'entrée (35) formant un guide lumineux entre le récepteur photosensible et ladite entrée optique (33).

3. Dispositif de caractérisation selon la revendication 2, dans lequel la source lumineuse comprend plusieurs fibres optiques de sortie (341) au niveau de la sortie optique, les fibres optiques de sortie étant réparties autour de ladite fibre optique d'entrée (342), les axes optiques des fibres optiques de sortie étant inclinés par rapport à l'axe optique de la fibre optique d'entrée au niveau de l'entrée optique, les axes optiques des fibres optiques de sortie et de la fibre optique d'entrée convergeant dans la cavité résonante (41).

4. Dispositif de caractérisation selon la revendication 3, dans lequel lesdites fibres optiques sont incluses dans une fibre optique multibrin.

5. Dispositif de caractérisation selon l'une quelconque des revendications 2 à 4, dans lequel ladite fibre optique d'entrée (35) formant un guide lumineux entre le récepteur photosensible et l'entrée optique comporte une extrémité logée dans la cavité résonnante (41), cette extrémité étant dépourvue de gaine métallique.

6. Dispositif de caractérisation selon l'une quelconque des revendications précédentes, dans lequel le spectre lumineux émis par la source de lumière est compris dans une bande spectrale allant de 100 nm à 1 mm de longueur d'onde.

7. Dispositif de caractérisation selon l'une quelconque des revendications précédentes, dans lequel l'entrée optique comporte un axe optique, et comprenant en outre un système de réglage (39) de la position de l'entrée optique dans la cavité résonnante selon l'axe optique de cette entrée optique.

8. Dispositif de caractérisation selon l'une quelconque des revendications précédentes, dans lequel l'entrée optique comporte un axe optique, et comprenant en outre :
- un support configuré pour maintenir l'échantillon (91) dans la cavité résonnante (41) de sorte qu'il soit traversé par l'axe optique de l'entrée optique ;
- un système de réglage (39) de la position relative entre l'échantillon et l'entrée optique (33) selon ledit axe optique.

9. Dispositif de caractérisation selon la revendication 7 ou 8, dans lequel le système de réglage (39) est configuré pour positionner l'entrée optique (33) à moins de 5mm d'un échantillon maintenu dans la cavité résonnante (41) par le support.

10. Dispositif de caractérisation selon l'une quelconque des revendications précédentes, dans lequel le système de contrôle (5) est en outre configuré pour :
- comparer lesdits échantillonnages simultanés à des mesures de réponses RPE et de photoluminescence d'un matériau de référence ;
- déterminer l'identité entre le matériau de l'échantillon placé dans la cavité résonnante et le matériau de référence en fonction du résultat de la comparaison.
